# EUROPEAN PATENT APPLICATION

(11) **EP 2 835 659 A1**
(43) Date of publication of application: **11.02.2015**
(21) Application number: 12877217.5
(22) Date of filing: 29.06.2012
(51) Int. Cl.: G01R 33/07, H02J 7/00

(54) **BATTERY IDENTIFICATION SYSTEM AND METHOD FOR ELECTRONIC DEVICE, AND ELECTRONIC DEVICE**

(30) Priority: 22.05.2012 CN 201210162961
(71) Applicant: ZTE Corporation, Shenzhen, Guangdong 518057 (CN)
(72) Inventor: TANG, Mingbing, Shenzhen, Guangdong 518057 (CN); CHEN, Junsheng, Shenzhen, Guangdong 518057 (CN)
(74) Representative: Lampis, Marco
(86) International application number: PCT/CN2012/077830
(87) International publication number: WO 2013/174058

(57) **Abstract**

A battery identification system and method for an electronic device, and an electronic device are disclosed. A Hall sensor is set in the electronic device, and a magnetic induction component is set in a first-capacity battery, wherein, when the first-capacity battery is in an installation position, the magnetic induction component is in a sensing area of the Hall sensor; and when the first-capacity battery is installed in the electronic device, the Hall sensor senses approach of the magnetic induction component, and outputs a control signal used for identifying the first-capacity battery. With a Hall sensor switch and a magnetic component in the battery, batteries with different capacities used in the electronic device can be identified.

## Description

### Technical Field

The present invention relates to the field of recycled rechargeable battery technology, and particularly, to a battery identification system and method for an electronic device, and an electronic device.

### Background of the Related Art

At present, the market demand for portable electronic devices, such as mobile terminals, notebook computers and tablet computers and so on, which use the recycled rechargeable batteries as the power sources, develops rapidly, and functions and applications of these electronic devices increase, which causes larger power consumption, and the devices have a greater demand for the battery capacity. However, due to the limitations of the existing battery technology, the battery capacity is always in direct proportion to the battery volume. It is difficult to satisfy both electric quantity sustainability and portability of the devices, and this causes that many devices are equipped with two or more sets of optional batteries, batteries with different capacities and volumes are used corresponding to different demands in the battery lock slot of the same device. Meanwhile, such application brings a plurality of problems, such as problems of identification, electric quantity calculation and electric quantity display and so on for the batteries with different capacities.

A lithium battery has advantages of large energy storage, long life, light weight and no memory effect and so on, and it has been widely used in the existing electronic devices. mAh is a measurement unit of the battery capacity, and it is specifically a total number of electrons that can be released for external use in the battery, which is converted into coulomb as a standard unit in physics. An international standard unit of the coulomb is an ampere-second of a current multiplying a time, that is, 1 mAh=0.001 ampere*3600 seconds=3.6 ampere-second=3.6 coulomb.

For the existing electronic devices, it mainly has the following three methods for implementing the calculation of electronic quantity:
1. Direct battery voltage monitoring method: the direct battery voltage monitoring method is simple and practicable; but the method has a low accuracy (20%) and lacks an effective protection on the battery;
2. Battery modeling method: a measurement accuracy (5%) of the electronic quantity is effectively improved with the battery modeling method, which is simple and practicable and not required to perform an initial estimation for the battery; but the establishment of data table is a complicated process, and it is also not so compatible with the batteries with different capacities or types; and
3. Coulombmeter detection method: a coulombmeter can accurately track the electronic quantity change of the battery, and the accuracy may reach 1%; however, the coulombmeter has a problem of the initial estimation for the battery, it is required to know a rated capacity, the present capacity and the present current loss, and an accuracy of the current resistance directly influences an accuracy of the electronic quantity.

Currently, the coulombmeter detection method is the most accurate and effective, the electronic devices such as the mainstream smartphone terminal and tablet computer all use the coulombmeter detection method, but only problems of the electronic quantity calculation and electronic quantity display of the batteries with fixed capacities can be solved with the coulombmeter detection method, and for the batteries with different capacities, the display electronic quantity cannot be accurately calculated with the coulombmeter detection method. Therefore, how to implement a simple, rapid and accurate identification for the batteries with different capacities becomes a technical problem required to be solved at present.

### Summary of the Invention

The object of the example of the present invention is to provide a battery identification system and method for an electronic device, and an electronic device, to identify batteries with different capacities used by the electronic device.

A battery identification method for an electronic device of the example of the present invention comprises:
setting a Hall sensor in the electronic device, and setting a magnetic induction component in a first-capacity battery, wherein, when the first-capacity battery is in an installation position, the magnetic induction component is in a sensing area of the Hall sensor; and
when the first-capacity battery is installed in the electronic device, the Hall sensor sensing approach of the magnetic induction component, then outputting a control signal used for identifying the first-capacity battery.

Alternatively, the Hall sensor is installed on a mainboard of the electronic device; and
the magnetic induction component is set at a place on a battery cover of the first-capacity battery corresponding to the Hall sensor.

Alternatively, the magnetic induction component comprises a magnet, and a magnetic pole of the magnet is vertical to a sensing surface of the Hall sensor.

Alternatively, an output terminal of the Hall sensor is connected to a processor;
when the first-capacity battery is installed in the electronic device, the Hall sensor senses the approach of the magnetic induction component, and outputs a low level signal to the processor; and according to the received low level signal, the processor identifies that the first-capacity battery is installed in the electronic device; and
when a second-capacity battery in which the magnetic induction component is not set is installed in the electronic device, the Hall sensor does not sense the approach of the magnetic induction component, and outputs a high level signal to the processor; and according to the received high level signal, the processor identifies that the second-capacity battery is installed in the electronic device.

Alternatively, the output terminal of the Hall sensor is connected to a universal Input/Output (I/O) interface or an interrupt pin of the processor.

Alternatively, the first-capacity battery and the second-capacity battery are respectively: a standard-capacity battery and a large-capacity battery, or, a large-capacity battery and a standard-capacity battery.

Alternatively, the Hall sensor is a switch-type Hall sensor or a linear Hall sensor.

A battery identification system for an electronic device of the example of the present invention comprises: a Hall sensor set in the electronic device, a processor connected with the Hall sensor, and a magnetic induction component set in a first-capacity battery of the electronic device; wherein, when the first-capacity battery is in an installation position, the magnetic induction component is in a sensing area of the Hall sensor;
the Hall sensor is configured to: when the first-capacity battery is installed in the electronic device, sense approach of the magnetic induction component, then output a control signal used for identifying the first-capacity battery to the processor; and
the processor is configured to: identify that a battery installed in the electronic device is the first-capacity battery according to the control signal.

Alternatively, the Hall sensor is configured to be installed on a mainboard of the electronic device; and
the magnetic induction component is set at a place on a battery cover of the first-capacity battery corresponding to the Hall sensor, and a magnetic pole of the magnetic induction component is vertical to a sensing surface of the Hall sensor.

Alternatively, the Hall sensor is configured to: when the first-capacity battery is installed in the electronic device, sense the approach of the magnetic induction component, and output a low level signal to the processor; and when a second-capacity battery in which the magnetic induction component is not set is installed in the electronic device, not sense the approach of the magnetic induction component, and output a high level signal to the processor; and
the processor is configured to: according the received low level signal, identify that the first-capacity battery is installed in the electronic device; and according to the received high level signal, identify that the second-capacity battery is installed in the electronic device.

Alternatively, an output terminal of the Hall sensor is connected to a universal I/O interface or an interrupt pin of the processor.

Alternatively, the Hall sensor is a switch-type Hall sensor or a linear Hall sensor.

An electronic device of the example of the present invention comprises: the above battery identification system.

Compared with the related art, the example of the present invention at least has the following advantages:
1. The batteries with different capacities in the electronic device can be identified, which provides multiple choices for the user, and enhances the competitive strength of the products in the market;
2. Two kinds of batteries with different capacities can be compatible in the same battery cavity; and
3. If the user selects a thin battery with a less capacity, costs of the whole machine can be decreased.

### Brief Description of Drawings

Here, the illustrated accompanying drawings are used to provide a further understanding of the present invention and constitute a part of the present invention. The schematic examples and illustrations thereof of the present invention are used to explain the present invention, but do not constitute an inappropriate limitation on the present invention. In the drawings:
FIG. 1 is a schematic diagram of an installation position of the Hall sensor in the example of the present invention.
FIG. 2 is a schematic diagram of an opening on the back cover above the mainboard in the example of the present invention.
FIG. 3 is a schematic diagram of a battery cover of the thick battery in the example of the present invention.
FIG. 4 is a schematic diagram of connection between the Hall sensor and the processor according to the example of the present invention.
FIG. 5 is a schematic diagram of assembly of the thin battery in the battery cavity.
FIG. 6 is a schematic diagram of assembly of the thick battery in the battery cavity.
FIG. 7 is a schematic diagram of fool-proofing design of the battery cover of the thin battery.
FIG. 8 is a schematic diagram of fool-proofing design of the battery cover of the thick battery.

### Preferred Embodiments of the Present Invention

The Hall sensor is a magnetic field sensor made according to Hall effect, and it is an integrated sensor composed of a Hall element and an accessory circuit of the Hall element. With the Hall effect, a control current I is connected at two ends of a semiconductor slice, and a uniform magnetic field with a magnetic induction intensity B is imposed in a vertical direction of the slice, and a Hall voltage with an electric potential difference of UH will be generated in the direction vertical to the current and the magnetic field. The Hall sensor is divided into two kinds: a linear Hall sensor and a switch-type Hall sensor. The linear Hall sensor consists of a Hall element, a linear amplifier and an emitter follower, and a linear relationship exists among an output analog quantity and output voltage of the linear Hall sensor and the imposed magnetic field intensity. The linear Hall device is mainly used for measurements of certain physical quantities, such as current measurement and displacement measurement. The switch-type Hall sensor consists of a voltage stabilizer, a Hall element, a differential amplifier, a Schmitt trigger and an output stage, and it outputs a digital quantity. When the imposed magnetic induction intensity exceeds an action point, the sensor outputs a low level, when the magnetic induction intensity drops below the action point, the sensor outputs an unchanged level, and until it drops to a release point, the sensor leaps from the low level to a high level. A lag between the action point and the release point makes an on-off action more reliable, thus the switch-type Hall sensor can be used for a proximity switch, revolution and car door status display and so on.

Therefore, the embodiment provides a battery identification method for an electronic device, which specifically includes:
setting a Hall sensor in the electronic device, and setting a magnetic induction component in a first-capacity battery, wherein, when the first-capacity battery is in an installation position, the magnetic induction component is in a sensing area of the Hall sensor; and
when the first-capacity battery is installed in the electronic device, the Hall sensor sensing approach of the magnetic induction component, then outputting a control signal used for identifying the first-capacity battery.

Preferably, the Hall sensor is installed on a mainboard of the electronic device; and
the magnetic induction component is set at a place on a battery cover of the first-capacity battery corresponding to the Hall sensor.

Preferably, the magnetic induction component includes a magnet, and a magnetic pole of the magnet is vertical to a sensing surface of the Hall sensor.

Preferably, an output terminal of the Hall sensor is connected to a processor;
when the first-capacity battery is installed in the electronic device, the Hall sensor senses the approach of the magnetic induction component, and outputs a low level signal to the processor; and according to the received low level signal, the processor identifes that the fiirst-capacity battery is installed in the electronic device; and
when a second-capacity battery in which the magnetic induction component is not set is installed in the electronic device, the Hall sensor does not sense the approach of the magnetic induction component, and outputs a high level signal to the processor consequently; and according to the received high level signal, the processor identifies that the second-capacity battery is installed in the electronic device.

Preferably, the first-capacity battery and the second-capacity battery can be a standard-capacity battery (i.e., a thin battery) and a large-capacity battery (i.e., a thick battery), etc.

The examples of the present invention will be described in detail in combination with the accompanying drawings below. It should be noted that the examples in the present invention and the characteristics in the examples can be optionally combined with each other in the condition of no conflict.

By taking the mobile phone terminal as an example, in the example of the present invention, in order to implement the identification of two kinds of batteries, namely the thick battery and the thin battery, with different capacities in the electronic device, the following scheme is mainly adopted.

### 1. The Hall sensor is placed on the mainboard, and the magnet is placed in a position corresponding to the Hall sensor on the battery cover.

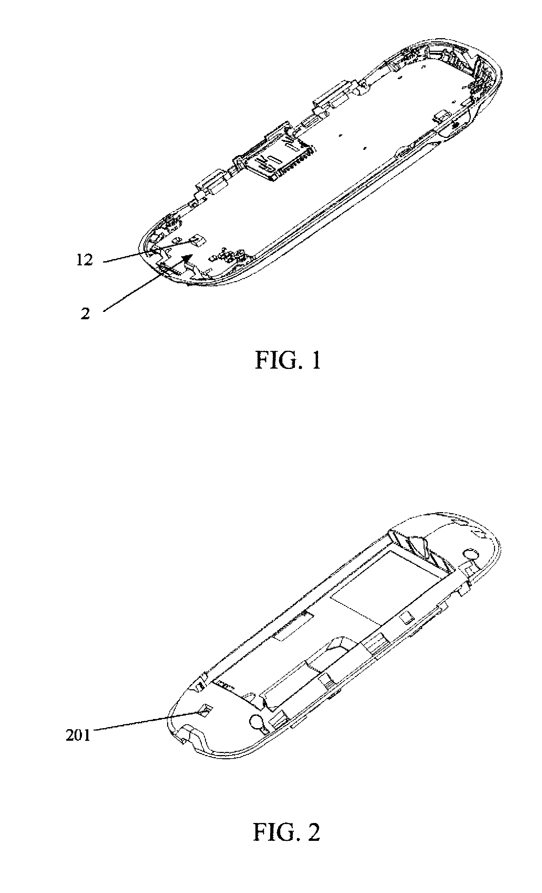

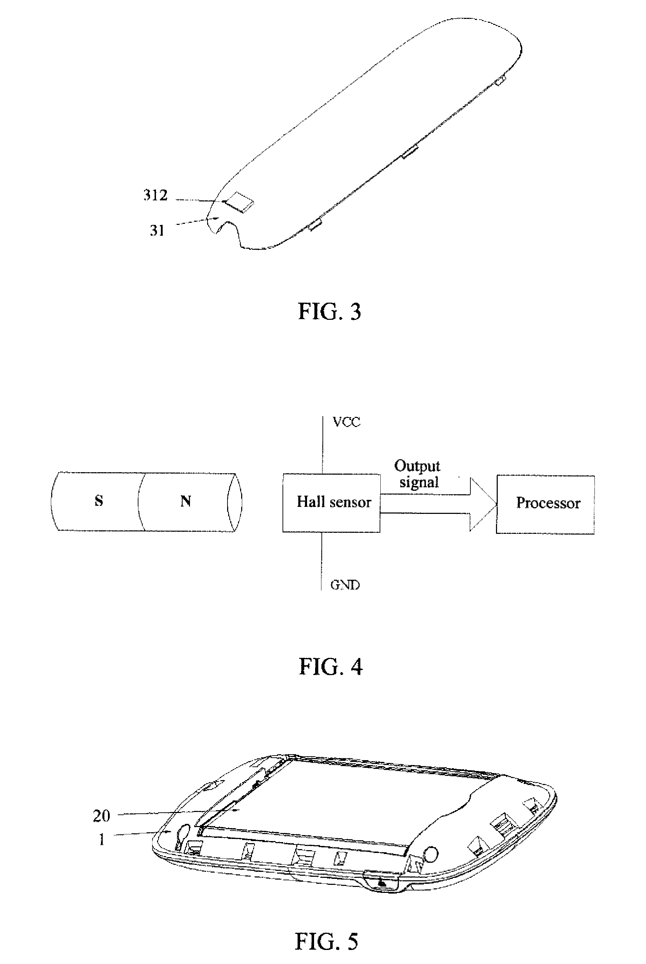

As shown in FIG. 1, a Hall sensor 12 is placed on a mainboard 2 of the terminal device. As shown in FIG. 3, a magnet 312 is placed in an upward position corresponding to the Hall sensor 12 on a battery cover 31 of the thick battery. It must be guaranteed that a magnetic pole of the magnet 312 is vertical to a sensing surface of the Hall device, which ensures that the Hall sensor 12 can sense the magnetic field change after closing the battery cover 31 and cut the magnetic field line.

In addition, as shown in FIG. 2, in order to avoid an interference of sensing with the magnetic field line, an opening 201 can be set in an upward position corresponding to the Hall sensor 12 on the back cover of the mobile phone.

It should be noted that, magnetic devices are not tried to be placed around the Hall sensor 12, and the sensing area of the Hall sensor 12 is vertical to a polarity of the magnet 312 on the battery cover 31. If the magnetic pole is parallel to the sensing surface of the Hall sensor 12, even though the battery cover is closed, the Hall sensor 12 still cannot sense the magnetic field change, and thus the sensor fails to output the corresponding control signal.

### 2. The output terminal of the Hall sensor is connected to the processor.

As shown in FIG. 4, the output terminal of the Hall sensor can be connected to an interrupt pin or a universal I/O interface of the processor. In a process of the electronic device starting up, by judging a status of the interrupt pin or the universal I/O interface, the capacity of the used battery is determined, and a corresponding drive program is started. Wherein, different battery capacities will mainly influence the charge current and the electric quantity display.

If the magnet is set on the battery cover, when the battery cover is closed, the magnet approaches to the Hall sensor, the Hall sensor senses the magnetic field change and cuts the magnetic field line, and an output signal of the Hall sensor changes from the high level to the low level. If the magnet is not set on the battery cover, when the battery cover is closed, since the Hall sensor does not sense the magnetic field change, the output pin of the Hall sensor keeps at the high level. The processor can identify the corresponding type of battery according to the high level and low level output by the Hall sensor.

### 3. The thick battery and the thin battery can be compatible in the same battery cavity.

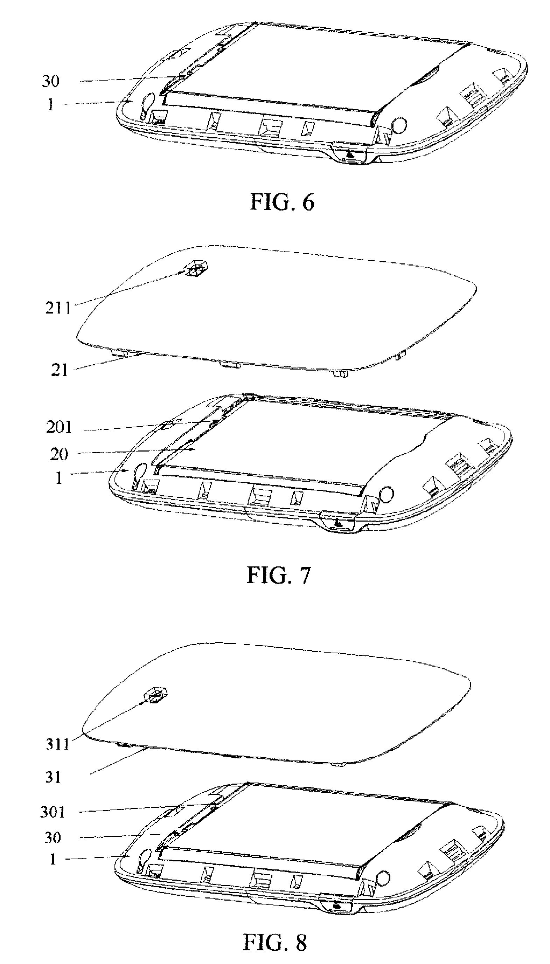

When the batteries with different capacities of the electronic device correspond to the batteries with different thicknesses, as shown in FIG. 5 and FIG. 6, a batter cavity in a back cover 1 is required to be compatible with two kinds of batteries with different thicknesses: a thin battery 20 and a thick battery 30. Moreover, it is also required to consider a function of fixing the battery in the related positions of the battery. For example, when the thin battery is placed, it is required to additionally increase a structure rib to fix the battery in a position relative to the battery on the back cover; and when the thick battery is placed, it is not required to additionally increase the structure rib to fix the battery in the position relative to the battery on the back cover.

In addition, it is required to consider the coordination between two positioning lock angles in front of the battery and the structure, and it is required to guarantee that shapes of battery lock angles and thicknesses of the thick battery and the thin battery are consistent, therefore, a feasibility of the assembly can be guaranteed. A diagram of assembly of the thin battery in the battery cavity is as shown in FIG. 5, and a diagram of assembly of the thick battery in the battery cavity is as shown in FIG. 6.

### 4. The fool-proofing design of the battery cover

In the above implementation scheme, with respect to the thick battery and the thin battery, there exists respectively a thick battery cover and a thin battery cover, thus, the fool-proofing design is made in the structure of the battery cover, as shown in FIG. 7 and FIG. 8, ribs 211 and 311 with the same size are set in different positions on the thick battery cover and the thin battery cover, and gaps are opened in corresponding positions on the thick battery and the thin battery. When the battery cover is closed, the rib 211 on a thin battery cover 21 can be embedded in the gap on the thin battery 20 to cooperate with the structure of the thick battery; and the rib 311 on a thick battery cover 31 can be embedded in the gap on the thick battery 30 to cooperate with the structure of the thin battery. Therefore, it is guaranteed that only the thin battery cover can be closed when the thin battery is placed in the battery compartment of the mobile phone, and only the thick battery cover can be closed when the thick battery is placed in the battery compartment of the mobile phone.

The above description is only the preferred examples of the present invention, which is not used to limit the present invention. The present invention can still have other various examples, the skilled familiar to the art can make various corresponding changes and transformations according to the example of the present invention without departing from the spirit and essence of the present invention, and these corresponding changes and transformations shall all fall into the protection scope of the appended claims of the present invention.

Apparently, the skilled in the art should understand that the modules or steps of the present invention mentioned above can be implemented through a universal calculating device, and they can be concentrated on a single calculating device or distributed in a network consisting of multiple calculating devices. Alternatively, the function modules or steps can be implemented through program codes which can be executed by the calculating device, thus, they can be stored in a storage device to be executed by the calculating device, and in some cases, the illustrated or described steps can be executed in a sequence different from here, or they can be made into multiple integrated circuit modules respectively, or multiple modules or steps of them can be made into a single integrated circuit module to be implemented. Therefore, the present invention is not limited to any combination of hardware and software in a specific form.

### Industrial Applicability

In the example of the present invention, the batteries with different capacities in the electronic device can be identified, which provides multiple choices for the user, and enhances the competitive strength of the products in the market; two kinds of batteries with different capacities can be compatible in the same battery cavity; and if the user selects a thin battery with a smaller capacity, costs of the whole machine can be decreased.

## Claims

1. A battery identification method for an electronic device, comprising:
setting a Hall sensor in the electronic device, and setting a magnetic induction component in a first-capacity battery, wherein, when the first-capacity battery is in an installation position, the magnetic induction component is in a sensing area of the Hall sensor; and
when the first-capacity battery is installed in the electronic device, the Hall sensor sensing approach of the magnetic induction component, then outputting a control signal used for identifying the first-capacity battery.

2. The method according to claim 1, wherein,
the Hall sensor is installed on a mainboard of the electronic device; and
the magnetic induction component is set at a place on a battery cover of the first-capacity battery corresponding to the Hall sensor.

3. The method according to claim 1, wherein,
the magnetic induction component comprises a magnet, and a magnetic pole of the magnet is vertical to a sensing surface of the Hall sensor.

4. The method according to claim 1 or 2 or 3, wherein, an output terminal of the Hall sensor is connected to a processor;
when the first-capacity battery is installed in the electronic device, the Hall sensor senses the approach of the magnetic induction component, and outputs a low level signal to the processor; and according to the received low level signal, the processor identifies that the first-capacity battery is installed in the electronic device; and
when a second-capacity battery in which the magnetic induction component is not set is installed in the electronic device, the Hall sensor does not sense the approach of the magnetic induction component, and outputs a high level signal to the processor; and according to the received high level signal, the processor identifies that the second-capacity battery is installed in the electronic device.

5. The method according to claim 4, wherein,
the output terminal of the Hall sensor is connected to a universal Input/Output (I/O) interface or an interrupt pin of the processor.

6. The method according to claim 1 or 2 or 3, wherein,
the first-capacity battery and the second-capacity battery are respectively a standard-capacity battery and a large-capacity battery, or, a large-capacity battery and a standard-capacity battery.

7. The method according to claim 1 or 2 or 3, wherein,
the Hall sensor is a switch-type Hall sensor or a linear Hall sensor.

8. A battery identification system for an electronic device, comprising: a Hall sensor set in the electronic device, a processor connected with the Hall sensor, and a magnetic induction component set in a first-capacity battery of the electronic device; wherein, when the first-capacity battery is in an installation position, the magnetic induction component is in a sensing area of the Hall sensor;
the Hall sensor is configured to: when the first-capacity battery is installed in the electronic device, sense approach of the magnetic induction component, then output a control signal used for identifying the first-capacity battery to the processor; and
the processor is configured to: identify that a battery installed in the electronic device is the first-capacity battery according to the control signal.

9. The system according to claim 8, wherein,
the Hall sensor is configured to be installed on a mainboard of the electronic device; and
the magnetic induction component is set at a place on a battery cover of the first-capacity battery corresponding to the Hall sensor, and a magnetic pole of the magnetic induction component is vertical to a sensing surface of the Hall sensor.

10. The system according to claim 8 or 9, wherein,
the Hall sensor is configured to: when the first-capacity battery is installed in the electronic device, sense the approach of the magnetic induction component, and output a low level signal to the processor; and when a second-capacity battery in which the magnetic induction component is not set is installed in the electronic device, not sense the approach of the magnetic induction component, and output a high level signal to the processor; and
the processor is configured to: according the received low level signal, identify that the first-capacity battery is installed in the electronic device; and according to the received high level signal, identify that the second-capacity battery is installed in the electronic device.

11. The system according to claim 10, wherein,
an output terminal of the Hall sensor is connected to a universal Input/Output (I/O) interface or an interrupt pin of the processor.

12. The system according to claim 8 or 9, wherein,
the Hall sensor is a switch-type Hall sensor or a linear Hall sensor.

13. An electronic device, comprising: the battery identification system according to any one of claims 8 to 12.
